# EUROPEAN PATENT SPECIFICATION

(11) **EP 4 233 492 B1**
(45) Date of publication and mention of the grant of the patent: **05.11.2025**
(21) Application number: 21830983.9
(22) Date of filing: 06.12.2021
(51) Int. Cl.: H05B 45/50, H05B 47/20, H05B 45/30, H02J 9/00

(54) **DRIVERS FOR EMERGENCY LIGHTING MEANS**
TREIBER FÜR NOTBELEUCHTUNGSMITTEL
PILOTES POUR MOYEN D'ÉCLAIRAGE D'URGENCE

(30) Priority: 16.12.2020 GB 202019854
(43) Date of publication of application: 30.08.2023
(73) Proprietor: Tridonic GmbH & Co KG, 6851 Dornbirn (AT)
(72) Inventor: FRANKLAND, James, Richmond, North Yorkshire DL10 6SL (GB)
(74) Representative: Rupp, Christian
(86) International application number: PCT/EP2021/084455
(87) International publication number: WO 2022/128586

(56) References cited:
- EP-A1- 3 435 743
- EP-A1- 3 820 250
- WO-A1-2020/008084
- US-A1- 2020 059 997
- US-A1- 2021 235 569

## Description

### TECHNICAL FIELD OF THE INVENTION

The invention relates to a driver for emergency lighting means.

### BACKGROUND OF THE INVENTION

The invention is in the field of emergency lighting, i.e. lighting means which are operated off a battery in case a mains voltage supply fails. The battery is charged by charging circuit supplied by the mains voltage. In such emergency lighting means, a e.g. bi-colour charge indicator is usually used as a visual indication to indicate states of the emergency lighting means, such as e.g. the state of charge of said battery, whether it be open circuit, short circuit or not able to reach a certain threshold after 24 hours of charge.

Emergency lighting means should undergo periodic tests of the lifetime of the battery provided for supplying the emergency lighting means in case of an emergency situation, which is defined as the failure of a supplying mains voltage.

A real lifetime test is, thus, periodically performed, in which the mains supply is switched off the emergency lighting means. Moreover, a controller of the emergency driver is configured to control the operation of the emergency lighting means and, at the same time, to note the lifetime of the battery for a sufficient operation of the emergency lighting means.

It is already known to provide emergency drivers with a status indicator LED, which is switched on (for example, in green colour, as mentioned above) in case the lifetime test has been successfully passed, which means that a rated minimum lifetime had been achieved by the real test. If the test has not been passed, the status indicator LED will remain dark.

EP3435743 A1 and WO2020/008084 A1 disclose known emergency lighting drivers for supplying emergency lighting means.

It is an objective to provide for an improved driver for emergency lighting means.

### SUMMARY OF THE INVENTION

The object of the present invention is achieved by the solution provided in the enclosed independent claims. Particularly, the invention is defined by an emergency lighting driver according to claim 1 and by a method for indicating a status of emergency lightings means according to claim 12. Further embodiments are set out in the dependent claims.

Advantageous implementations of the present invention are further defined in the dependent claims.

According to a first aspect the invention relates to an emergency lighting driver for supplying an emergency lighting means, comprising: a control circuit, and at least one status indicator LED, wherein the control circuit is arranged to perform a duration time test with regard to an operation of the emergency lighting means off a battery connected to the emergency lighting driver and issue a quantitative information of the test result via at least one light parameter of the at least one status indicator LED.

This provides the advantage that the health of the battery can be monitored by means of a microcontroller which allows to quantitatively represent the test results via the at least one light parameter of the at least one status indicator LED.

In a preferred embodiment, the quantitative information represents the duration time test result as an absolute value or relative to the minimum required value thereof.

In a preferred embodiment, the control circuit is configured to encode the quantitative information on the basis of a brightness of a light emitted by the status indicator LED.

This provides the advantage that a well-known quantity like the brightness can be used in order to quantify the health of the battery.

In a preferred embodiment, the control circuit is configured to encode the quantitative information on the basis of a specific modulation of the brightness of the at least one status indicator LED.

This provides the advantage that a well-known quantity like a specific modulation of the brightness can be used in order to quantify the health of the battery.

In a preferred embodiment, the control circuit is configured to encode the quantitative information by supplying the at least one status indicator LED with a signal comprising a pulse-width-modulation (PWM).

This provides the advantage that a well-known quantity like the PWM can be used in order to quantify the health of the battery.

In a preferred embodiment, the light parameter comprises a wavelength range visible to the human eye.

This provides the advantage that even a human can get information about the battery health.

In a preferred embodiment, the light parameter comprises a wavelength range not visible to the human eye.

In a preferred embodiment, the light parameter is detectable by a light sensor, wherein, in particular, the light sensor is a camera of a handled device such as for example a mobile phone.

This provide the advantage that information about the battery health can be obtained in a precise quantitative way.

In a preferred embodiment, the controller is a microcontroller or an ASICs.

This provides the advantage that a well-known controller is used as to monitor the health of the battery.

In a preferred embodiment, the emergency driver comprises a low-voltage-power-supply, LVPS, on a secondary side of the driver.

In a preferred embodiment, the control circuit is configured to adjust the light parameter continuously in order to represent the quantitative information.

This provide the advantage that the information about the health of the battery is adjusted in a precise way.

In a preferred embodiment, the control circuit is configured to adjust the light parameter in discrete steps in order to represent the quantitative information.

According to a second aspect, the invention relates to a method for indicating a status of an emergency lighting means, comprising: performing a duration time test with regard to an operation of the emergency lighting means off a battery connected to and emergency lighting driver, and
issuing a quantitative information of a duration test result via at least one light parameter of at least one status indicator LED.

According to a third aspect, the invention relates to a use of a status indicator LED of an emergency lighting driver for transmitting a quantitative information of a duration test of an emergency lighting means.

### BRIEF DESCRIPTION OF THE DRAWINGS

The invention will be explained in the followings together with the figures.
- Fig. 1: shows an embodiment of an emergency lighting driver for supplying an emergency lighting means according to an embodiment;
- Fig. 2: shows a schematic method for indicating a status of an emergency lighting means according to an embodiment; and
- Fig. 3: shows a schematic method for indicating a status of an emergency lighting means according to an embodiment.

### DETAILED DESCRIPTION OF THE PREFERRED EMBODIMENTS

Aspects of the present invention are described herein in the context of an emergency lighting driver for supplying an emergency lighting means.

The present invention is described more fully hereinafter with reference to the accompanying drawings, in which various aspects of the present invention are shown. This invention however may be embodied in many different forms and should not be construed as limited to the various aspects of the present invention presented through this disclosure. Rather, these aspects are provided so that this disclosure will be thorough and complete, and will fully convey the scope of the present invention to those skilled in the art. The various aspects of the present invention illustrated in the drawings may not be drawn to scale. Rather, the dimensions of the various features may be expanded or reduced for clarity. In addition, some of the drawings may be simplified for clarity. Thus, the drawings may not depict all of the components of a given apparatus.

Various aspects of an emergency lighting driver for supplying an emergency lighting means will be presented. However, as those skilled in the art will readily appreciate, these aspects may be extended to aspects of emergency lighting driver for supplying an emergency lighting means without departing from the invention.

The term "LED luminaire" shall mean a luminaire with a light source comprising one or more LEDs or OLEDs. LEDs are well-known in the art, and therefore, will only briefly be discussed to provide a complete description of the invention.

It is further understood that the aspect of the present invention might contain integrated circuits that are readily manufacturable using conventional semiconductor technologies, such as complementary metal-oxide semiconductor technology, short "CMOS". In addition, the aspects of the present invention may be implemented with other manufacturing processes for making optical as well as electrical devices. Reference will now be made in detail to implementations of the exemplary aspects as illustrated in the accompanying drawings. The same references signs will be used throughout the drawings and the following detailed descriptions to refer to the same or like parts.

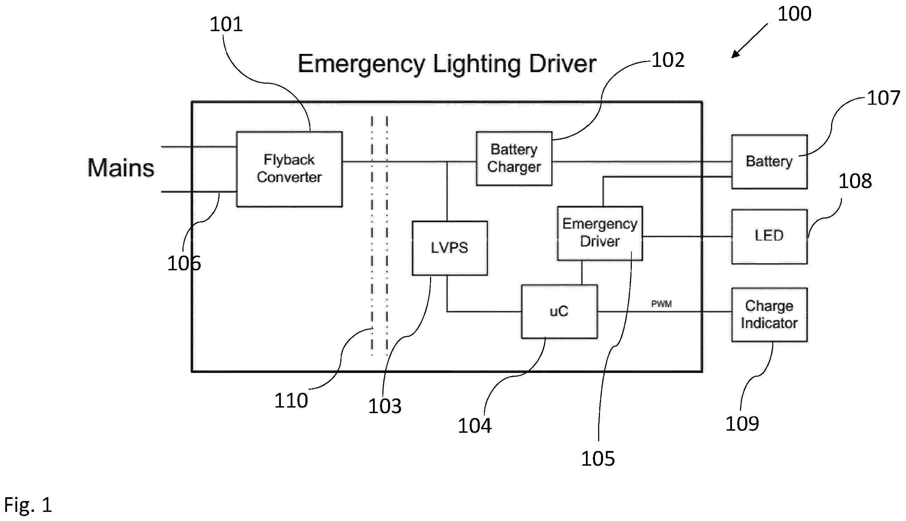

Fig. 1 shows an embodiment of an emergency lighting driver 100 for supplying an emergency lighting means 108 according to an embodiment.

The emergency lighting driver 100 for supplying an emergency lighting means 108 comprises a control circuit or controller 104, and at least one visual and/or acoustic feedback means, in the example a status indicator LED 109. The control circuit 104 is arranged to perform a duration time test with regard to an operation of the emergency lighting means 108 off a battery 107 connected to the emergency lighting driver 100, and issue a quantitative information of the test result via at least one light parameter of the at least one feedback means, such as the status indicator LED 109.

Generally, the feedback means are designed to issue a signal the variations of which can be detected by the human eye and/or ear. Alternatively, the signal can be varied (in order to represent the quantitative information) such that the variation can be read (or read only) by a sensing apparatus, such as a handheld device with a camera, e.g. a mobile telephone.

In Fig. 1, the emergency lighting driver 100 further comprises an isolated converter, such as e.g. a flyback converter 101 on a primary which is fed with a filtered and rectified mains voltage 106 (the filter and rectification stage are not shown). Moreover, on the secondary side of the isolated converter, the driver 100 comprises a battery charger 102, a low-voltage-power-supply 103 for the microcontroller 104, the microcontroller 104 and an emergency driver 105. The primary side and the secondary side of the driver 100 are separated by an isolation barrier 110, which can be implemented by the isolated converter. The battery charger 102 is connected to the battery 107. Furthermore, the battery 107 is connected to an emergency driver 105. The emergency driver 105 is further connected to the emergency lighting means 108. Furthermore, the controller or microcontroller 104 is connected to the status indicator LED 109.

In this embodiment, advantageously, a visual indication of the battery health on basic platforms that use a single colour status indicator is possible, since the design of the emergency lighting driver 100 includes the microcontroller 104. As the health of the battery deteriorates, the corresponding test result is feedback as a quantitative information. E.g. the intensity of the status indicator LED or charge indicator LED 109 would reduce to zero to indicate a reducing battery health. The zero intensity point would be when there is not enough capacity in the battery 107 to achieve the specified duration, i.e. if it only works for 2.75 hours and it is a 3 hours system. It should be noted that this is not a safety risk, in fact, it is rather the opposite as basic systems currently still illuminate the status indicator LED 109 as the battery is under charge, but there is no guarantee that the capacity in the battery 107 is capable of achieving the specified duration.

With the inclusion of the microcontroller 104, it is possible to monitor the battery health, whether it be under voltage to short circuit, over voltage to open circuit or depleting capacity leading to a specified duration not been met. On basic, for instance, the charge indicator LED 109 could be turned off if the battery was over-voltage, under-voltage after 24 hours charge or does not have enough capacity to meet the specified duration.

In another embodiment, the charge indicator LED 109 can be dim as the capacity reduces, thus, encroaching on the specified duration.

The charge indicator LED 109 would turn off if, by dimming of the charge indicator LED 109, the battery capacity reduces to the level where it will not meet the required duration. This, advantageously, gives important information to the customer on basic level systems where dual colour LEDs are not used and communication is not available.

Basic level emergency systems give a visual indication to the customer of battery health, such as an early indication that batteries will not meet the specified duration even though they are still charging. By law, customers have to perform a manual duration test.

Embodiments of the invention provide the advantage that the customer would not have to time for each individual basic module or emergency lighting device 100, as the unit would time itself and if the duration does not met the requirement, then the charge indicator LED 109 is turned off. This could save a lot of maintenance costs for the customer.

Therefore, embodiments of the present invention have the advantage that maintenance costs are reduced.

Basic level emergency lighting drivers 100 can now advantageously provide battery health information over the charge indicator LED 109.

Therefore, embodiments of the present invention have the advantage that the battery health can be shown on a single colour charge indicator LED 109 in basic lighting systems 100.

For example, the charge indicator LED 109 could dim as the battery capacity reduces, giving a visual indication to the customer that the batteries are reducing in capacity and will need changing soon. Once the battery does not meet the specified duration, the charge indicator LED 109 is configured to turn off, even though the battery 107 is charging, to indicate a battery replacement is necessary.

Moreover, there are maintenance savings as well, since customers do not need to manually time each individual basic fitting to make sure that the desired time duration length is met.

If the duration is not met, then the charge indicator LED 109 extinguishes to indicate that a battery replacement is necessary. This advantageously saves a significant amount in maintenance costs, compared to having to time a whole building walking around manually checking all the emergency lights and noting how long they have lasted for.

Therefore, compared to prior art, an additional intelligence is introduced in such a status indicator LED 109. This status indicator LED 109 can be used to not only convey a binary information "test passed/test not passed", but actually to incorporate the transmission of the quantitative information in case the test has been passed.

At least, one emission characteristic or quantitative information of the preferably mono-color LED is made dependent on the percentage as how much the true test achieved an operation of the LEDs 108 going beyond the rated minimum lifetime of the battery 107.

In an embodiment, the quantitative information represents the duration time test result as an absolute value or relative to the minimum required value thereof. Moreover, the control circuit 104 can be configured to encode the quantitative information on the basis of the brightness of a light emitted by the status indicator LED 109.

In another embodiment, the control circuit 104 is configured to encode the quantitative information on the basis of a specific modulation of the brightness of the at least one status indicator LED 109. Furthermore, the control circuit 104 can be configured to encode the quantitative information by supplying the at least one status indicator LED 109 with a signal comprising a pulse-width-modulation (PWM).

The control circuit 104 can be configured to adjust the light parameter continuously in order to represent the quantitative information or the control circuit 104 can be configured to adjust the light parameter in discrete steps in order to represent the quantitative information.

According to one aspect, the emission characteristic, especially the brightness, is adapted such that it is visible to the human eye.

According to another aspect, the adaptation of the at least one emission parameter of the status indicator LED is adapted such that it is readable by a light sensor, which could be for example a camera of a handheld device, such as for example a mobile phone. When read out with such technical means, the read-out means could then indicate a true numerical value of the excess lifetime being the result of the periodic test.

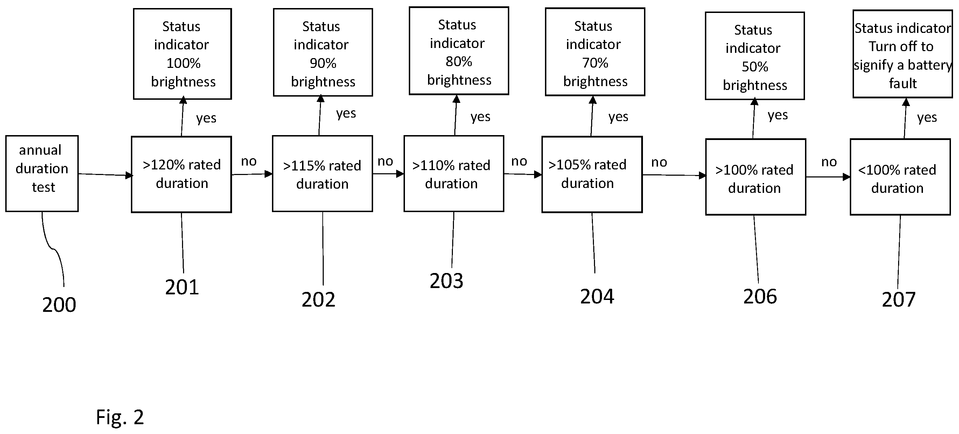

Fig. 2 shows a schematic method for indicating a status of an emergency lighting means according to an embodiment.

In step 200, an annual time duration test of the battery 107 is performed.

If the rated duration of the battery 107 is above 120%, then the status indicator LED 109 is configured to show 100% of brightness in step 201.

If the rated duration of the battery 107 is less than 120% but greater than 115%, then the status indicator LED 109 is configured to show 90% of brightness in step 202.

If the rated duration of the battery 107 is less than 115% but greater than 110%, then the status indicator LED 109 is configured to show 80% of brightness in step 203.

If the rated duration of the battery 107 is less than 110% but greater than 105%, then the status indicator LED 109 is configured to show 70% of brightness in step 204.

If the rated duration of the battery 107 is less than 105% but greater than 100%, then the status indicator LED 109 is configured to show 50% of brightness in step 206.

If the rated duration of the battery 107 is less than 100%, then the status indicator LED 109 is configured to turn off to show a battery fault in step 207.

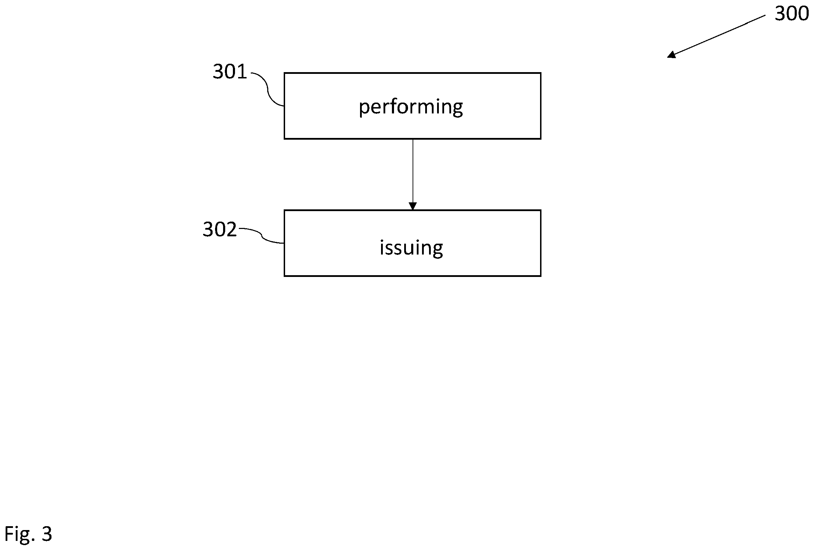

Fig. 3 shows a schematic method 300 for indicating a status of an emergency lighting means 108 according to an embodiment.

The method 300 comprises the steps of:
- performing 301 a duration time test with regard to an operation of an emergency lighting means 108 off a battery 107 connected to an emergency lighting driver 100, and
- issuing 302 a quantitative information of a duration test result via at least one light parameter of at least one status indicator LED 109.

All features of all embodiments described, shown and/or claimed herein can be combined with each other.

While various embodiments of the present invention have been described above, it should be understood that they have been presented by way of example only and not limitation. Thus, the breadth and scope of the present invention should not be limited by any of the above-described embodiments. Rather, the scope of the invention should be defined in accordance with the following claims and their equivalence.

Although the invention has been illustrated and described with respect to one or more implementations, equivalent alternations and modifications will occur to those skilled in the art upon the reading of the understanding of the specification and the annexed drawings.

## Claims

1. Emergency lighting driver (100) for supplying an emergency lighting means (108), comprising:
- a control circuit (104); and
- at least one status indicator LED (109),
- wherein the control circuit (104) is arranged to
∘ perform a duration time test with regard to an operation of the emergency lighting means (108) off a battery (107) connected to the emergency lighting driver (100), and
∘ issue a quantitative information of a test result of the duration time test via at least one light parameter of the at least one status indicator LED (109),
- wherein the at least one light parameter is detectable by a light sensor, and
- wherein the light sensor is a camera of a mobile phone external to the emergency lighting driver (100).

2. Emergency lighting driver (100) of claim 1, wherein the quantitative information represents the duration time test result as an absolute value or relative to the minimum required value thereof.

3. The emergency lighting driver (100) of claim 1 or 2, wherein the control circuit (104) is configured to encode the quantitative information on the basis of a brightness of a light emitted by the at least one status indicator LED (109).

4. The emergency lighting driver (100) of claim 3, wherein the control circuit (104) is configured to encode the quantitative information on the basis of a specific modulation of the brightness of the at least one status indicator LED (109).

5. The emergency lighting driver (100) of claim 1, wherein the control circuit (104) is configured to encode the quantitative information by supplying the at least one status indicator LED (109) with a signal comprising a pulse-width-modulation, PWM.

6. The emergency lighting driver (100) of any one of the preceding claims, wherein the at least one light parameter comprises a wave length range visible to the human eye.

7. The emergency lighting driver (100) of any one of the preceding claims 1 to 5, wherein the at least one light parameter comprises a wave length range not visible to the human eye.

8. The emergency lighting driver (100) of any one of the preceding claims, wherein the controller (104) is a microcontroller or an ASICs.

9. The emergency lighting driver (100) of any one of the preceding claims, wherein the emergency lighting driver (100) comprises a low-voltage-power-supply (103), LVPS, on a secondary side of the driver.

10. The emergency lighting driver (100) of any one of the preceding claims, wherein the control circuit (104) is configured to adjust the at least one light parameter continuously in order to represent the quantitative information.

11. The emergency lighting driver (100) of any one of the preceding claims 1-9, wherein the control circuit (104) is configured to adjust the at least one light parameter in discrete steps in order to represent the quantitative information.

12. A method (300) for indicating a status of an emergency lighting means, comprising:
- performing (301) a duration time test with regard to an operation of an emergency lighting means (108) off a battery (107) connected to an emergency lighting driver (100), and
- issuing (302) a quantitative information of a test result of the duration time test via at least one light parameter of at least one status indicator LED (109),
wherein the at least one light parameter is detectable by a light sensor, and wherein the light sensor is a camera of a mobile phone external to the emergency lighting driver (100).

13. Use of the emergency lighting driver (100) of claim 1.

## Patentansprüche

1. Notbeleuchtungstreiber (100) zur Versorgung eines Notbeleuchtungsmittels (108), umfassend:
- eine Steuerschaltung (104); und
- mindestens eine Statusanzeige-LED (109),
wobei die Steuerschaltung (104) so eingerichtet ist,
- einen Dauertest in Bezug auf den Betrieb des Notbeleuchtungsmittels (108) mit einer an den Notbeleuchtungstreiber (100) angeschlossenen Batterie (107) durchzuführen, und
- eine quantitative Information über das Testergebnis des Dauertests über mindestens einen Lichtparameter der mindestens einen Statusanzeige-LED (109) auszugeben,
wobei der mindestens eine Lichtparameter durch einen Lichtsensor erfassbar ist, und
wobei der Lichtsensor eine Kamera eines Mobiltelefons außerhalb des Notbeleuchtungstreibers (100) ist.

2. Notbeleuchtungstreiber (100) nach Anspruch 1, wobei die quantitative Information das Ergebnis des Dauertests als absoluten Wert oder relativ zum Mindestwert darstellt.

3. Notbeleuchtungstreiber (100) nach Anspruch 1 oder 2, wobei die Steuerschaltung (104) so konfiguriert ist, die quantitative Information auf Basis der Helligkeit des von der mindestens einen Statusanzeige-LED (109) ausgestrahlten Lichts zu codieren.

4. Notbeleuchtungstreiber (100) nach Anspruch 3, wobei die Steuerschaltung so konfiguriert ist, die quantitative Information auf Basis einer spezifischen Modulation der Helligkeit der mindestens einen Statusanzeige-LED (109) zu codieren.

5. Notbeleuchtungstreiber (100) nach Anspruch 1, wobei die Steuerschaltung (104) so konfiguriert ist, die quantitative Information durch Versorgung der mindestens einen Statusanzeige-LED (109) mit einem Signal mit Pulsweitenmodulation (PWM) zu codieren.

6. Notbeleuchtungstreiber (100) nach einem der vorhergehenden Ansprüche, wobei der mindestens eine Lichtparameter einen für das menschliche Auge sichtbaren Wellenlängenbereich umfasst.

7. Notbeleuchtungstreiber (100) nach einem der vorhergehenden Ansprüche 1 bis 5, wobei der mindestens eine Lichtparameter einen für das menschliche Auge nicht sichtbaren Wellenlängenbereich umfasst.

8. Notbeleuchtungstreiber (100) nach einem der vorhergehenden Ansprüche, wobei der Controller (104) ein Mikrocontroller oder ein ASIC ist.

9. Notbeleuchtungstreiber (100) nach einem der vorhergehenden Ansprüche, wobei der Notbeleuchtungstreiber (100) eine Niederspannungsstromversorgung (103), LVPS, auf der Sekundärseite des Treibers umfasst.

10. Notbeleuchtungstreiber (100) nach einem der vorhergehenden Ansprüche, wobei die Steuerschaltung (104) so konfiguriert ist, den mindestens einen Lichtparameter kontinuierlich anzupassen, um die quantitative Information darzustellen.

11. Notbeleuchtungstreiber (100) nach einem der vorhergehenden Ansprüche 1-9, wobei die Steuerschaltung (104) so konfiguriert ist, den mindestens einen Lichtparameter in diskreten Schritten anzupassen, um die quantitative Information darzustellen.

12. Verfahren (300) zur Anzeige eines Status eines Notbeleuchtungsmittels, umfassend:
- Durchführung (301) eines Dauertests in Bezug auf den Betrieb eines Notbeleuchtungsmittels (108) mit einer an einen Notbeleuchtungstreiber (100) angeschlossenen Batterie (107), und
- Ausgabe (302) einer quantitativen Information über das Testergebnis des Dauertests über mindestens einen Lichtparameter von mindestens einer Statusanzeige-LED (109), wobei der mindestens eine Lichtparameter durch einen Lichtsensor erfassbar ist, und wobei der Lichtsensor eine Kamera eines Mobiltelefons außerhalb des Notbeleuchtungstreibers (100) ist.

13. Verwendung des Notbeleuchtungstreibers (100) nach Anspruch 1.

## Revendications

1. Bloc d'alimentation pour éclairage de secours (100) destiné à alimenter un moyen d'éclairage de secours (108), comprenant : un circuit de commande (104) ; et au moins une LED indicatrice d'état (109),
dans lequel le circuit de commande (104) est conçu pour : effectuer un test de durée concernant le fonctionnement du moyen d'éclairage de secours (108) à partir d'une batterie (107) connectée au bloc d'alimentation (100), et
fournir une information quantitative du résultat du test de durée via au moins un paramètre lumineux de la ou des LED indicatrices d'état (109),
dans lequel le ou les paramètres lumineux sont détectables par un capteur de lumière, et
dans lequel le capteur de lumière est une caméra de téléphone mobile externe au bloc d'alimentation (100).

2. Bloc d'alimentation selon la revendication 1, dans lequel l'information quantitative représente le résultat du test de durée comme une valeur absolue ou relative à la valeur minimale requise.

3. Bloc d'alimentation selon la revendication 1 ou 2, dans lequel le circuit de commande (104) est configuré pour encoder l'information quantitative sur la base de la luminosité de la lumière émise par la ou les LED indicatrices d'état (109).

4. Bloc d'alimentation selon la revendication 3, dans lequel le circuit de commande est configuré pour encoder l'information quantitative sur la base d'une modulation spécifique de la luminosité de la ou des LED indicatrices d'état (109).

5. Bloc d'alimentation selon la revendication 1, dans lequel le circuit de commande (104) est configuré pour encoder l'information quantitative en alimentant la ou les LED indicatrices d'état (109) avec un signal comprenant une modulation de largeur d'impulsion (PWM).

6. Bloc d'alimentation selon l'une quelconque des revendications précédentes, dans lequel le ou les paramètres lumineux comprennent une plage de longueurs d'onde visible à l'œil humain.

7. Bloc d'alimentation selon l'une quelconque des revendications 1 à 5, dans lequel le ou les paramètres lumineux comprennent une plage de longueurs d'onde non visible à l'œil humain.

8. Bloc d'alimentation selon l'une quelconque des revendications précédentes, dans lequel le contrôleur (104) est un microcontrôleur ou un ASIC.

9. Bloc d'alimentation selon l'une quelconque des revendications précédentes, dans lequel le bloc d'alimentation (100) comprend une alimentation basse tension (103), LVPS, sur le côté secondaire du bloc.

10. Bloc d'alimentation selon l'une quelconque des revendications précédentes, dans lequel le circuit de commande (104) est configuré pour ajuster le ou les paramètres lumineux de manière continue afin de représenter l'information quantitative.

11. Bloc d'alimentation selon l'une quelconque des revendications 1 à 9, dans lequel le circuit de commande (104) est configuré pour ajuster le ou les paramètres lumineux par étapes discrètes afin de représenter l'information quantitative.

12. Procédé (300) pour indiquer un état d'un moyen d'éclairage de secours, comprenant :
effectuer (301) un test de durée concernant le fonctionnement d'un moyen d'éclairage de secours (108) à partir d'une batterie (107) connectée à un bloc d'alimentation (100), et
fournir (302) une information quantitative du résultat du test de durée via au moins un paramètre lumineux d'au moins une LED indicatrice d'état (109),
dans lequel le ou les paramètres lumineux sont détectables par un capteur de lumière, et dans lequel le capteur de lumière est une caméra de téléphone mobile externe au bloc d'alimentation (100).

13. Utilisation du bloc d'alimentation pour éclairage de secours (100) selon la revendication 1.
